# EUROPEAN PATENT APPLICATION

(11) **EP 4 417 413 A1**
(43) Date of publication of application: **21.08.2024**
(21) Application number: 22881052.9
(22) Date of filing: 12.10.2022
(51) Int. Cl.: B32B 15/08, H05K 1/03

(54) **MULTILAYER STRUCTURE INCLUDING INSULATING LAYER**

(30) Priority: 14.10.2021 JP 2021169042
(71) Applicant: Denka Company Limited, Tokyo 103-8338 (JP)
(72) Inventor: ARAI, Toru, Tokyo 103-8338 (JP); KANTO, Ryosuke, Tokyo 103-8338 (JP)
(74) Representative: Müller-Boré & Partner Patentanwälte PartG mbB
(86) International application number: PCT/JP2022/038065
(87) International publication number: WO 2023/063357

(57) **Abstract**

A multilayer structure comprises:
at least one insulating layer(s);
at least one resin layer(s); and
at least one copper foil(s) each having a smooth surface and a roughened surface,
wherein the insulating layer contains an olefin-aromatic vinyl compound-aromatic polyene copolymer and a surface modifier,
wherein the resin layer contains one or more selected from the group consisting of polyimide (PI), liquid crystal polymer (LCP), polyphenylene ether (PPE), polyfunctional aromatic vinyl resin (ODV), epoxy resin, and the same composition as in the insulating layer,
wherein at least one surface of each of the respective insulating layer(s) is bonded to a smooth surface of the copper foil, and
wherein, for each of the respective resin layer(s):
at least one surface of the resin layer is bonded to the roughened surface of the copper foil, and the resin layer is not bonded to the smooth surface of the copper foil; or
both surfaces of the resin layer are not bonded to the copper foil.

## Description

### FIELD OF THE INVENTION

The present invention relates to a multilayer structure having an insulating layer made of a composition having high adhesion to a smooth surface of copper foil.

### BACKGROUND OF THE INVENTION

Along with the shift of communication frequency to the gigahertz or higher frequency bands, a need for multilayer substrates made of CCL or FCCL including an insulating material with low dielectric properties has increased. Although fluorine-based resins such as perfluoroethylene have excellent low dielectric constant, low dielectric loss, and excellent heat resistance, application to multi-layer substrates is difficult due to difficulty in forming processability and film formability, and problem in adhesion to a copper foil of wiring. On the other hand, although substrates and insulating materials made of post-curing resins such as epoxy resins, unsaturated polyester resins, polyimide resins, and phenolic resins have been widely used due to heat resistance and ease of handling, improvement is desired as an insulating material for high frequencies due to having a relatively high dielectric constant and dielectric loss (Patent Literature 1).

Therefore, attention has been focused on hydrocarbon-based resins that inherently have low dielectric properties. In order to make a curable resin from a hydrocarbon-based resin, which is inherently a thermoplastic resin, it is necessary to introduce a functional group. However, in general, a radical or a functional group reacting to heat has a polarity, so that low dielectric properties deteriorate. In introduction of a functional group composed only of a hydrocarbon such as aromatic vinyl group, an intermolecular reaction between expensive hydrocarbon-based monomers is used in many cases (Patent Literature 2), which is not economical in many cases. In Patent Literature 3, a cured product made of an ethylene-olefin (aromatic vinyl compound)-aromatic polyene copolymer having a specific composition and blending obtained with use of a specific coordination polymerization catalyst, i.e., a non-polar vinyl compound copolymer, is shown. In the technique, only one of the two vinyl groups of the aromatic polyene (divinylbenzene) is selectively copolymerized and the remaining vinyl group is preserved, so that a hydrocarbon-based copolymerized macromonomer having an aromatic vinyl functional group is easily obtained. A cured product obtained from a similar composition including an olefin-aromatic vinyl compound-aromatic polyene copolymer and auxiliary raw materials has a low dielectric constant and a low dielectric loss tangent, and provides a wide range of physical properties from soft to hard depending on the selection of composition and proper auxiliary materials (Patent Literatures 4 and 5). Further, these materials may exhibit high adhesion (adhesive strength) to a roughened surface of copper foil as shown in the examples. Accordingly, it is considered that the materials are suitable as various substrate materials and insulating materials for high-frequency signals.

However, especially in applications such as high-frequency transmission lines such as microstrip lines, antennas, interlayer insulation materials for multilayer substrates, and coverlays, the insulating material is in contact with the smooth surface of copper foil, being required to have high adhesive strength (peel strength) to the smooth surface of a copper foil. In particular, sheet-shaped or film-shaped interlayer insulating materials are in contact with the smooth surface of copper foil at least partially or at least on one side, and are required to have high adhesive strength to the surface. However, the disclosed conventional patent literature discloses no technique for imparting high adhesion (adhesive strength) to the smooth surface of copper foil to the insulating material.

### PRIOR ART

### Patent Literature

[Patent Literature 1] Japanese Patent Laid-Open No. 6-192392
[Patent Literature 2] Japanese Patent Laid-Open No. 2004-087639
[Patent Literature 3] Japanese Patent Laid-Open No. 2007-217706
[Patent Literature 4] International Publication No. WO-2021/112087
[Patent Literature 5] International Publication No. WO-2021/112088

### SUMMARY OF THE INVENTION

### TECHNICAL PROBLEM

Different from the above-described conventional art, provision of a multilayer structure useful as multilayer substrate having an insulating layer I, which exhibits high adhesion to a smooth surface of copper foil, (also referred to as an "interlayer insulating material" in the specification) has been desired.

### SOLUTION TO PROBLEM

That is, the present application can provide the following aspects for solving the problem.

### Aspect 1.

A multilayer structure comprising:
at least one insulating layer(s);
at least one resin layer(s); and
at least one copper foil(s) each having a smooth surface and a roughened surface,
wherein the insulating layer contains an olefin-aromatic vinyl compound-aromatic polyene copolymer and a surface modifier,
wherein the resin layer contains one or more selected from the group consisting of polyimide (PI), liquid crystal polymer (LCP), polyphenylene ether (PPE), polyfunctional aromatic vinyl resin (ODV), epoxy resin, and the same composition as in the insulating layer,
wherein at least one surface of each of the respective insulating layer(s) is bonded to a smooth surface of the copper foil, and
wherein, for each of the respective resin layer(s):
   at least one surface of the resin layer is bonded to the roughened surface of the copper foil, and the resin layer is not bonded to the smooth surface of the copper foil; or
   both surfaces of the resin layer are not bonded to the copper foil.

### Aspect 2

The multilayer structure according to aspect 1, wherein at least one surface of the insulating layer has a recessed portion in the lamination direction, and the copper foil is bonded to be fitted in the recessed portion, with a part of the surface is bonded to the smooth surface of the copper foil, and another part of the surface bonded to the resin layer.

### Aspect 3

The multilayer structure according to aspect 1 or 2, wherein the surface modifier is a silane coupling agent.

### Aspect 4

The multilayer structure according to any one of aspects 1 to 3, wherein the olefin-aromatic vinyl compound-aromatic polyene copolymer satisfies all of the following conditions (1) to (4):
(1) The copolymer has a number average molecular weight of 500 or more and less than 100000;
(2) The aromatic vinyl compound monomer is an aromatic vinyl compound having 8 or more and 20 or less carbon atoms, and the content of the aromatic vinyl compound monomer unit is 0 to 70 mass% or less, or 0 to 98 mass% or less;
(3) The aromatic polyene is one or more selected from polyenes having 5 to 20 carbon atoms and having a plurality of vinyl groups and/or vinylene groups in the molecule, and the content of the vinyl groups and/or the vinylene groups derived from aromatic polyene units is 1.5 pieces or more and less than 20 pieces per number average molecular weight; and
(4) The olefin is one or more selected from olefins having 2 or more and 20 or less carbon atoms, and a content of olefin monomer units is 10 mass% or more, wherein a total amount of the olefin monomer units, aromatic vinyl compound monomer units, and aromatic polyene monomer units is 100 mass%.

### Aspect 5

The multilayer structure according to any one of aspects 1 to 4, wherein the insulating layer further includes one or more selected from the following (a) to (c):
(a) curing agent;
(b) one or more resins selected from hydrocarbon-based elastomers, polyphenylene ether-based resins, and aromatic polyene-based resins; and
(c) polar monomer.

### Aspect 6

The multilayer structure according to any one of aspects 1 to 5, wherein the content of the surface modifier in the insulating layer is 0.001 to 10 parts by mass relative to 100 parts by mass of the olefin-aromatic vinyl compound-aromatic polyene copolymer.

### Aspect 7

A cured multilayer structure produced by curing the multilayer structure according to any one of aspects 1 to 6.

### Aspect 8

A high frequency transmission line, a multilayer CCL substrate, a multilayer FCCL substrate, an antenna, or a coverlay, comprising the cured multilayer structure according to aspect 7.

### ADVANTAGEOUS EFFECT OF INVENTION

In the present invention, an insulating layer exhibiting a low dielectric constant and dielectric loss tangent, low water absorption, and high insulation is bonded to a smooth surface of copper foil with high adhesive strength (peel strength), so that a multilayer structure useful as high-frequency multilayer substrate can be provided.

### BRIEF DESCRIPTION OF THE DRAWINGS

Figure 1 is a diagram showing a fundamental unit structure which may be included in a part or whole of a multilayer structure of the present invention.
Figure 2 is a diagram showing a specific structure which may be included in a part or whole of a multilayer structure of the present invention.
Figure 3 is a diagram showing a specific structure which may be included in a part or whole of a multilayer structure of the present invention.
Figure 4 is a diagram showing a modified example of the fundamental unit.

### DETAILED DESCRIPTION OF THE INVENTION

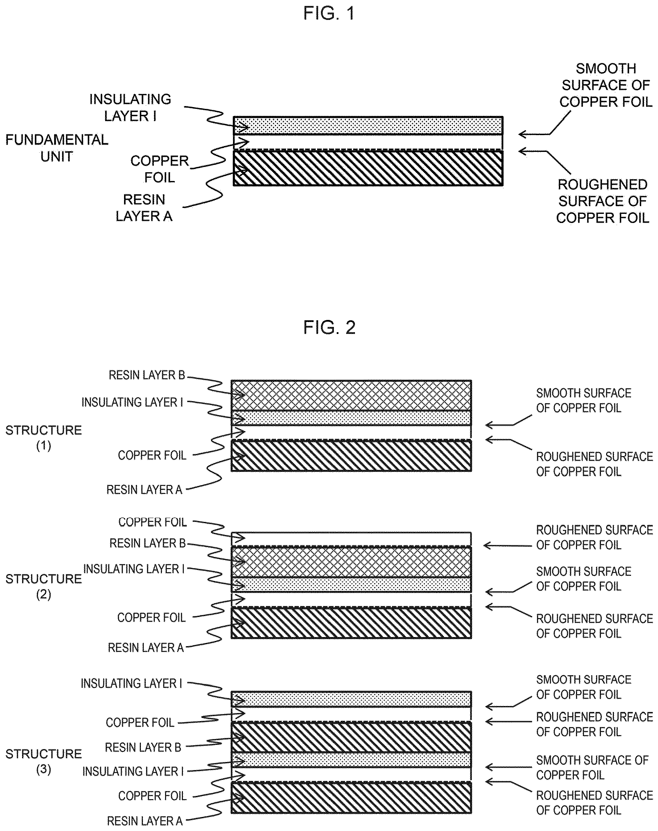

The fundamental unit of the multilayer structure is a structure (shown in Figure 1) including a copper foil, a resin layer bonded to a roughened surface of the copper foil, and an insulating layer bonded to a smooth surface of the copper foil. The multilayer structure may contain one or more of the fundamental units, and may contain a combination of the fundamental unit and another layer.

The insulating layer(s) of the present multilayer structure conceptionally includes an interlayer insulating material and a coverlay. Further, the interlayer insulating material conceptionally includes an interlayer adhesive material and a bonding sheet. The sheet conceptionally includes a film. A term film described in the specification conceptionally includes a sheet also. The composition according to the present invention is described in more detail below. The term composition in the present specification conceptionally includes a varnish. That is, a composition particularly in a liquid state is described as varnish.

### <Copper foil and roughened surface>

The copper foil (one or more sheets) included in the multilayer structure may be any copper foil that may be used for wiring and substrates. The thickness thereof is typically in a range of 1 to 500 µm, preferably 5 to 50 µm, though not particularly limited. The copper foil is preferably applicable to high frequencies, and may be a rolled copper foil or an electrolytic copper foil. The copper foil has a roughened surface (also known as matte surface, and referred to as M surface in some cases) and a smooth surface (or glossy surface or shined surface, or may be referred to as S surface in some cases). For example, the roughened surface of copper foil may be achieved by a copper foil having a surface roughness (maximum height) Rz defined in JIS B0601 :2001 of preferably 5 µm or less, particularly preferably 3 µm or less. For example, the roughened surface of the copper foil may be achieved by a copper foil having a surface roughness (maximum height) Rz defined in JIS B0601 :2001 of preferably more than 0.5 µm. Such a copper foil may be obtained from Furukawa Electric Co., Ltd., JX Nippon Mining & Metals Corporation, or Mitsui Mining & Smelting Co., Ltd., etc.

### <Smooth surface of copper foil>

The smooth surface of copper foil is a surface of a copper foil used for wiring and substrates, which is not a roughened surface, and is relatively smooth compared to the roughened surface. The smooth surface typically has a surface roughness (maximum height) Rz of 0.5 µm or less as defined in JIS B0601:2001, and as described above, being a relatively smooth surface compared to the roughened surface, or having relatively high gloss without particular limitation. Those skilled in the art may readily identify and distinguish the smooth and roughened surfaces of a copper foil. Since the roughened surface of copper foil is used for bonding to a base film or a substrate, the interlayer insulating material of a multilayer substrate is required to have high adhesion to the remaining smooth surface.

### <Resin layer>

The resin layer(s) included in the multilayer structure are made of resin selected from polyimide (PI), liquid crystal polymer (LCP), polyphenylene ether (PPE), polyfunctional aromatic vinyl resin (ODV), epoxy resin, and the same resin (composition) as in the insulating layer described above. The resin layer is typically a component of substrate as a part of a multilayer structure. The resin layer may be bonded to the roughened surface of copper foil, or be not bonded to copper foil at all. Thus the resin layer can be distinguished from the insulating layer. The case where the resin layer has the same composition as in the insulating layer means that the resin layer "contains an olefin-aromatic vinyl compound-aromatic polyene copolymer and a surface modifier" as in the insulating layer. The thickness of the resin layer may be freely selected, and is preferably 10 µm to 1 mm. From the viewpoint of improving the strength of the structure and reducing the coefficient of linear expansion (CTE), the resin layer preferably contains a reinforcing material such as filler and glass cloth. One surface of the resin layer may be bonded to the roughened surface of copper foil in advance. Further, the polyimide (PI) conceptionally includes a modified polyimide (MPI) having a more reduced dielectric constant, dielectric loss tangent, and water absorption rate. As the polyphenylene ether, a curable PPE having a functional group is preferred.

### <Preferred structure>

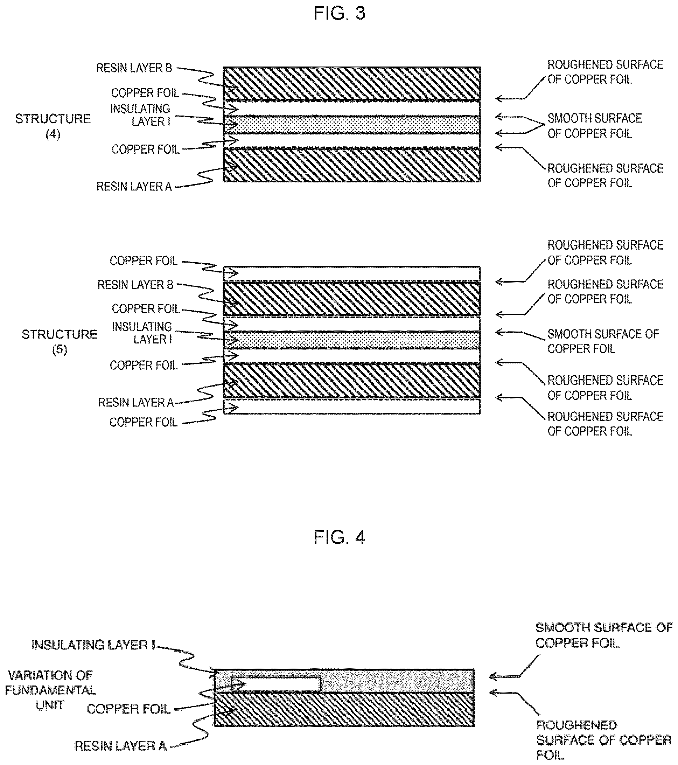

In a preferred embodiment, a part or whole of the multilayer structure has the fundamental unit shown in Figure 1 or a repeating structure thereof, and may also have a further insulating layer, a further resin layer, or a further copper foil. Specific examples may include one or a combination of the structures (1) to (5) shown in Figure 2 and Figure 3.

In an embodiment, a part or whole of the fundamental unit may be replaced with a variation of the fundamental unit shown in Figure 4. In an embodiment, a part or whole of the structures (1) to (5) may be replaced with a variation of the fundamental unit shown in Figure 4. That is, the configuration may be such that at least one surface of the insulating layer has a recessed portion in the lamination direction, and the copper foil is bonded to be fitted in the recessed portion, with a part of the surface bonded to the smooth surface of copper foil, and another part of the surface bonded to the resin layer. It means that such a configuration in which the resin layer is partially directly bonded to the insulating layer is allowed. Such replacement may be performed, for example, by partially removing the copper foil by etching and replacing that portion with an insulating layer. In other words, the area of each layer included in the multilayer structure is not necessarily uniform, and may be, for example, divided into islands or provided with recesses. Further, although one or more of the layers of the multilayer structure may have through holes or via holes (through hole vias, interstitial vias, blind vias, buried vias, etc.), these holes are considered to be excluded from the definition of the layer structure of the multilayer structure in the specification (the presence of holes is omitted in the drawings).

### <Insulating layer>

The thickness of the insulating layer included in the multilayer structure may be freely selected, and is typically 1 µm to 500 µm, preferably 5 µm to 100 µm. The composition of the insulating layer in the multilayer structure contains an olefin-aromatic vinyl compound-aromatic polyene copolymer as main component, and preferably further contains 0.01 to 5 parts by mass of a surface modifier, preferably a silane coupling agent, relative to 100 parts by mass of the olefin-aromatic vinyl compound-aromatic polyene copolymer. At least a part of the insulating layer is in contact with the smooth surface of copper foil. In the case of multiple insulating layers, at least one surface of all the insulating layers is in contact with the smooth surface of copper foil. In other words, in the case of multiple insulating layers, each of the insulating layers contact with the smooth surface of copper foil. In an embodiment, it is preferable that neither side of the insulating layer be bonded to the roughened surface of the copper foil. The olefin-aromatic vinyl compound-aromatic polyene copolymer in an amount of 30 mass% or more, preferably 50 mass% or more, more preferably 70 mass% or more, may be contained relative to the whole composition. The present olefin-aromatic vinyl compound-aromatic polyene copolymer may be obtained by copolymerizing each of the monomers of an olefin, an aromatic vinyl compound and an aromatic polyene.

The olefin monomer is one or more selected from α-olefins having 2 to 20 carbon atoms and cyclic olefins having 5 to 20 carbon atoms, which is a compound containing substantially no oxygen, no nitrogen and no halogen, composed of carbon and hydrogen. Examples of the α-olefins having 2 to 20 carbon atoms include ethylene, propylene, 1-butene, 1-hexene, 1-octene, 1-decane, 1-dodecane, 4-methyl-1-pentene, and 3,5,5-trimethyl-1-hexene. Examples of the cyclic olefins having 5 to 20 carbon atoms include norbornene and cyclopentene. The olefin that may be preferably used is a combination of ethylene with an α-olefin other than ethylene or a cyclic olefin, or ethylene alone. In the case where the olefin is ethylene alone or in the case where the mass ratio of α-olefin components other than ethylene contained/ethylene component is preferably 1/7 or less, more preferably 1/10 or less, the resulting cured product may have an increased adhesive strength to a copper foil or copper wiring, which is preferable. More preferably, the content of α-olefin monomer components other than ethylene contained in the copolymer is 6 mass% or less, most preferably 4 mass% or less, or the olefin is ethylene alone. In a combination of ethylene and an α-olefin other than ethylene, the glass transition temperature of the finally resulting cured ethylene-α-olefin-aromatic vinyl compound-aromatic polyene copolymer may be freely adjusted in an approximate range of -60°C to -10°C depending on the type and content of the α-olefin.

The aromatic vinyl compound monomer is an aromatic vinyl compound having 8 to 20 carbon atoms, and examples thereof include styrene, paramethylstyrene, paraisobutylstyrene, various vinylnaphthalenes, and various vinylanthracenes.

The aromatic polyene monomer is a polyene having 5 or more and 20 or less carbon atoms with a plurality of vinyl groups and/or vinylene groups in the molecule, which is a compound having an aromatic vinyl structure such as preferably various divinylbenzenes including ortho-, meta-, or para-divinylbenzene or a mixture thereof, divinylnaphthalene, divinylanthracene, p-2-propenylstyrene, and p-3-butenylstyrene, containing substantially no oxygen, no nitrogen and no halogen, composed of carbon and hydrogen. Alternatively, a bifunctional aromatic vinyl compound such as 1,2-bis(vinylphenyl)ethane (abbreviation: BVPE) described in Japanese Patent Laid-Open No. 2004-087639 may be used. Among these, ortho-, meta-, and para-divinylbenzenes, or mixtures thereof, are preferably used, mixtures of meta- and para-divinylbenzenes are most preferably used. In the present specification, such a divinylbenzene is referred to as divinylbenzenes. Use of divinylbenzenes as the aromatic polyene is preferred, because high curing efficiency and easy curing can be achieved in curing treatment.

Each monomer of the olefins, aromatic vinyl compounds, and aromatic polyenes may also include other olefins containing polar groups such as oxygen atoms and nitrogen atoms, aromatic vinyl compounds containing oxygen atoms, nitrogen atoms, etc., or aromatic polyenes containing oxygen atoms, nitrogen atoms, etc., though the total mass of the monomers containing the polar groups is preferably 10 mass% or less, more preferably 3 mass% or less of the total mass of the composition. Most preferably, none of monomers containing the polar group is contained. With a content controlled to 10 mass% or less, the dielectric properties (low dielectric constant/low dielectric loss) of a cured product obtained by curing the composition may be improved.

The olefin-aromatic vinyl compound-aromatic polyene copolymer preferably satisfies any one or more of the following conditions (1) to (4), more preferably satisfies the all:
(1) The copolymer has a number average molecular weight of 500 or more and less than 100000;
(2) The aromatic vinyl compound monomer is an aromatic vinyl compound having 8 or more and 20 or less carbon atoms, and the content of the aromatic vinyl compound monomer unit is 0 to 98 mass% or less, preferably 0 to 70 mass% or less;
(3) The aromatic polyene is one or more selected from polyenes having 5 to 20 carbon atoms and having a plurality of vinyl groups and/or vinylene groups in the molecule, and the content of the vinyl groups and/or the vinylene groups derived from aromatic polyene units is 1.5 pieces or more and less than 20 pieces per number average molecular weight; and
(4) The olefin is one or more selected from olefins having 2 or more and 20 or less carbon atoms, and a content of olefin monomer units is 10 mass% or more, wherein a total amount of the olefin monomer units, aromatic vinyl compound monomer units, and aromatic polyene monomer units is 100 mass%.

The copolymer may have the number average molecular weight (Mn) of 500 or more and less than 100000. In the present invention, the number average molecular weight of 500 or more and less than 100000 means that the molecular weight in terms of standard polystyrene obtained by the GPC (gel permeation chromatography) method falls within that range.

The content of the aromatic vinyl compound monomer units in the copolymer may be 0 mass% or more and 98 mass% or less, more preferably 0 mass% or more and 70 mass% or less, and most preferably 10 mass% or more and 60 mass% or less. A content of the aromatic vinyl compound monomer units of 70 mass% or less is preferred, because a cured product of the finally resulting composition has a glass transition temperature lower than about room temperature, so that the toughness and elongation at low temperatures may be improved. With a content of the aromatic vinyl compound monomer unit of 10 mass% or more, the copolymer has an improved aromaticity, so that effects of improving compatibility with a flame retardant and a filler, avoiding bleeding of a flame retardant, and improving filling property of a filler may be obtained. Further, with a content of the aromatic vinyl compound monomer unit of 10 mass% or more, a cured product of the composition having high adhesive strength to a copper foil or copper wiring may be also obtained.

In the copolymer, the content of vinyl groups and/or vinylene groups derived from aromatic polyene units (preferably the content of vinyl groups) may be 1.5 pieces or more and less than 20 pieces, preferably 2 pieces or more and less than 20 pieces, and most preferably 3 pieces or more and less than 20 pieces, per number average molecular weight. With a content of the vinyl groups and/or vinylene groups of 1.5 pieces or more, the cross-linking efficiency increases, and a cured product with a sufficient cross-linking density may be obtained. The content of vinyl groups derived from aromatic polyene units (divinylbenzene units) per number average molecular weight in the copolymer may be determined by comparing the molecular weight (Mn) in terms of standard polystyrene obtained by the GPC (gel permeation chromatography) method known to those skilled in the art and the content of vinyl groups derived from the aromatic polyene units obtained by ¹H-NMR measurement. As an example, in the case where the content of vinyl groups derived from aromatic polyene units (divinylbenzene units) in the copolymer is 0.45 mass% based on comparison of the intensity of each peak area obtained by ¹H-NMR measurement, and the number average molecular weight in terms of standard polystyrene obtained by the GPC measurement is 36000, the molecular weight of the vinyl group derived from the aromatic polyene units in the number average molecular weight is the product thereof or 162, which is divided by the formula weight of the vinyl group of 27 to obtain 6.0. In other words, the content of vinyl groups derived from the aromatic polyene units per number average molecular weight in the copolymer is determined to be 6.0. The assignment of peaks obtained in ¹H-NMR measurements of the copolymer is known from the literature. A method for determining the composition of a copolymer by comparing peak areas obtained by ¹H-NMR measurement is also known. Furthermore, the accuracy of the composition may be improved by adding the data of the peak areas of the ¹³C-NMR spectrum and ratios thereof measured in a known quantitative mode to the ¹H-NMR measurement method. In the specification, the content of divinylbenzene units in the copolymer is determined from the peak intensity of vinyl groups derived from divinylbenzene units (by ¹H-NMR measurement). In other words, from the content of vinyl groups derived from divinylbenzene units, the content of divinylbenzene units is determined on the assumption that the one vinyl group is derived from one divinylbenzene unit in the copolymer.

In the copolymer, the content of olefin monomer units is preferably 10 mass% or more, more preferably 30 mass% or more, and most preferably 30 mass% or more. The total amount of the olefin monomer units, the aromatic vinyl compound monomer units, and the aromatic polyene monomer units is 100 mass%. With a content of the olefin monomer units of 10 mass% or more, the finally resulting cured product has improved toughness (elongation) and impact resistance, so that cracks during curing and cracks during a heat cycle test of the cured product are unlikely to occur. In the copolymer, the content of olefin monomer units is preferably 90 mass% or less.

The copolymer may be a mixture of multiple types of copolymers to achieve desirable physical properties. In the copolymer, specific preferred examples of the olefin-aromatic polyene copolymer containing no aromatic vinyl compound monomer units include an ethylene-divinylbenzene copolymer, an ethylene-propylene-divinylbenzene copolymer, an ethylene-1-butene-divinylbenzene copolymer, an ethylene-1-hexene-divinylbenzene copolymer, and an ethylene-1-octene-divinylbenzene copolymer.

In the copolymer, examples of the olefin-aromatic vinyl compound-aromatic polyene copolymer containing aromatic vinyl compound monomer units include an ethylene-styrene-divinylbenzene copolymer, an ethylene-propylene-styrene-divinylbenzene copolymer, an ethylene-1-hexene-styrene-divinylbenzene copolymer, and ethylene-1-octene-styrene-divinylbenzene copolymer.

### <Surface modifier>

The composition of the present invention contains a surface modifying agent for the purpose of improving adhesion to a copper foil for wiring. In particular, the purpose is to increase the adhesive strength (peel strength) to the smooth surface of a copper foil. The amount (content) of the surface modifier used relative to 100 parts by mass of the olefin-aromatic vinyl compound-aromatic polyene copolymer may preferably be in the range of 0.001 to 10 parts by mass, more preferably in the range of 0.01 to 5 parts by mass, and most preferably in the range of 0.01 to 1 part by mass. With an amount of the surface modifier used of 10 parts by mass or less, a cured product obtained from the composition has a low dielectric constant and low dielectric loss tangent, so that the object of the present invention is satisfied.

A known surface modifier may be used in the present invention. Examples of such a surface modifier include a silane-based surface modifier (also known as silane coupling agent), a titanate-based surface modifier, and an isocyanate-based surface modifier. Preferably, a silane-based surface modifier is used. One or a plurality of these surface modifiers may be used. Such a silane-based surface modifier is available from Shin-Etsu Chemical Co., Ltd., Dow Corning Corp., or Evonik Industries AG. The silane-based surface modifier is a silane compound having a functional group and a hydrolytically condensable group in the molecule. Examples of the functional group include a vinyl group such as vinyl, methacryloxy, acryloxy and styryl, an amino group, an epoxy group, a mercapto group, a sulfide group, an isocyanate group, and a halogen. Considering high adhesion to glass, the functional group may preferably be one or more selected from a vinyl group, an amino group, an epoxy group, a methacryloxy group, and an acryloxy group, and most preferably one or more selected from an amino group, a methacryloxy group, and an epoxy group. One or more of the functional groups may be present in the molecule. One or more of the surface modifiers may be used. Examples of the silane-based surface modifier having a vinyl group as functional group include vinyltrimethoxysilane and vinyltriethoxysilane. Examples of the silane coupling agent having a styryl group as functional group include p-styryl trimethoxysilane. Examples of the silane coupling agent having an acryloxy group as functional group include 3-acryloxypropyl trimethoxysilane. Examples of the silane coupling agent having a methacryloxy group as functional group include 3-methacryloxypropyl trimethoxysilane, 3-methacryloxypropyl triethoxysilane, 3-methacryloxypropylmethyl dimethoxysilane, and 3-methacryloxypropylmethyl diethoxysilane. Examples of the silane coupling agent having an epoxy group as a functional group include 3-glycidoxypropyl trimethoxysilane, 3-glycidoxypropyl triethoxysilane, 3-glycidoxypropylmethyl diethoxysilane, and 2-(3,4-epoxy cyclohexyl)ethyltrimethoxysilane. Examples of the silane coupling agent having an amino group as functional group include 3-aminopropyl trimethoxysilane, 3-aminopropyl triethoxysilane, N-2-(aminoethyl)-3-aminopropylmethyl dimethoxysilane, N-2 -(aminoethyl)-3-aminopropylethyl dimethoxysilane, N-2-(aminoethyl)-3-aminopropylmethyl diethoxysilane, N-2-(aminoethyl)-3-aminopropyl trimethoxysilane, N-2-(aminoethyl)-3-aminopropyl triethoxysilane, N-phenyl-3-aminopropyl trimethoxysilane, bis(3-trimethoxysilylpropyl)amine, bis(3-triethoxysilylpropyl)amine, and N-(n-butyl)-3-aminopropyl trimethoxysilane. Although the examples described above have a methoxy group and an ethoxy group as hydrolytically condensable groups, a triisopropoxy group and an acetoxy group may also be used. Particularly preferably, a silane-based surface modifier having one or more functional groups selected from a vinyl group such as methacryloxy, acryloxy, and styryl, an amino group, an epoxy group, and a mercapto group is used.

A composition containing the copolymer and the surface modifier (hereinafter also simply referred to as "composition") may be prepared as follows. In the case where the copolymer component is in a resin state, the surface modifier may be mixed by a known kneading method using, for example, a twin-screw kneader, various rolls, and various kneaders. In the case where the copolymer component is in a varnish state, the surface modifier is added to the varnish, stirred and mixed to be dissolved.

The composition of the present invention may further include (a) a curing agent, (b) one or a plurality of resins selected from a hydrocarbon-based elastomer, a polyphenylene ether-based resin, and an aromatic polyene-based resin and (c) one or a plurality of polar monomers, in addition to the present copolymer and the surface modifier.

### <(a) Curing agent>

As the curing agent that may be used in the composition of the present invention, conventionally known radical generators and curing agents that may be used for polymerization or curing of aromatic polyenes and aromatic vinyl compounds. Examples of such a curing agent include a radical polymerization initiator, a cationic polymerization initiator, and an anionic polymerization initiator, and preferably a radical polymerization initiator may be used. An organic peroxide-based (peroxide) or azo-based polymerization initiator is preferred, and may be freely selected according to the application and conditions. A catalog listing organic peroxides may be downloaded from an NOF website, for example, https://www.nof.co.jp/business/chemical/chemical-product01. The organic peroxides are also described in the catalogs of FUJIFILM Wako Pure Chemical Corporation and Tokyo Chemical Industry Co., Ltd. The curing agent for use in the present invention is available from these companies. Alternatively, a known photopolymerization initiator with use of light, ultraviolet rays, or radiation may be used as the curing agent. Examples of the curing agent with use of a photopolymerization initiator include a photoradical polymerization initiator, a photocationic polymerization initiator, and a photoanionic polymerization initiator. Such a photoinitiator is available, for example, from Tokyo Chemical Industry Co., Ltd. Furthermore, curing by direct radiation or electron beams is also possible. Crosslinking and curing may also be performed by heat of raw materials contained without containing a curing agent.

The amount of the curing agent used is not particularly limited, but typically preferably 0.01 to 10 parts by mass relative to 100 parts by mass of the composition. It is preferable that a curing agent and a solvent be excluded from the composition. In the case of using a curing agent such as a peroxide and an azo-based polymerization initiator, the curing treatment is performed at an appropriate temperature and time in consideration of the half-life. The conditions in this case may be freely selected according to the curing agent, and is generally a temperature range of about 50°C to 200°C is suitable.

In the varnish of the present invention, the total content of component (b), that is, "one or more resins selected from a hydrocarbon-based elastomer, a polyphenylene ether-based resin, and an aromatic polyene-based resin", may be preferably in the range of 1 to 200 parts by mass relative to 100 parts by mass of the copolymer. Addition of the component (b) has the effect of improving the mechanical properties of a cured product obtained from the varnish.

### <Hydrocarbon-based elastomer>

The amount of the hydrocarbon-based elastomer used in the composition of the present invention is preferably 1 to 200 parts by mass, more preferably 1 to 100 parts by mass, and most preferably 1 to 50 parts by mass, relative to 100 parts by mass of the copolymer. The hydrocarbon-based elastomer that may be suitably used in the composition of the present invention has a number average molecular weight of preferably 100 or more and 100000 or less, more preferably 1000 or more and 4500 or less. The hydrocarbon-based elastomers that may be suitably used in the composition of the present invention preferably includes one or more elastomers selected from an ethylene-based or propylene-based elastomer, a conjugated diene-based polymer, an aromatic vinyl compound-conjugated diene-based block copolymer or random copolymer, and a hydride (hydrogenated product) thereof. Examples of the ethylene-based elastomer include an ethylene-α-olefin copolymer such as an ethylene-octene copolymer and an ethylene-1-hexene copolymer, EPR, and EPDM. Examples of the propylene-based elastomer include an atactic polypropylene, a polypropylene having low stereoregularity, and a propylene-α-olefin copolymer such as propylene-1-butene copolymer. The hydrocarbon-based elastomers may be modified through introduction of a functional group by reaction with a compound such as maleic anhydride, or the like.

Examples of the conjugated diene polymer include polybutadiene and 1,2-polybutadiene. Examples of the aromatic vinyl compound-conjugated diene-based block copolymer or random copolymer and a hydride (hydrogenated product) thereof include SBS, SIS, SEBS, SEPS, SEEPS and SEEBS. 1,2-Polybutadiene that may be suitably used is available, for example, from NIPPON SODA CO., LTD., as liquid polybutadiene under product names: Product Names B-1000, 2000, and 3000. Examples of the copolymer containing a 1,2-polybutadiene structure that may be suitably used include "Ricon 100" manufactured by TOTAL CRAY VALLEY S.A. The conjugated diene polymer and the hydride thereof may be modified by introducing functional groups with a compound such as maleic anhydride. In the case where one or more resins selected from the hydrocarbon-based elastomers are in a liquid state (approximately 300000 mPa·s or less) at room temperature (25°C) in particular, the amount used thereof is preferably 150 parts by mass or less, more preferably 1 to 30 parts by mass, and most preferably 1 to 20 parts by mass relative to 100 parts by mass of the copolymer, from the viewpoint of handleability and moldability in an uncured state (handleability as thermoplastic resin).

### <Polyphenylene ether>

As the polyphenylene ether (also referred to as "polyphenylene ether-based resin"), a commercially available known polyphenylene ether may be used. The number average molecular weight of the polyphenylene ether may be freely selected, and is preferably 10000 or less, most preferably 5000 or less, in consideration of molding processability of the composition. The number average molecular weight may preferably be 500 or more.

In the case of addition for curing the composition of the present invention, it is preferable that the terminal of the molecule be modified with a functional group. Further, in the case of addition for curing the composition of the present invention, it is preferable that one molecule have a plurality of functional groups. For example, a modified polyphenylene ether is preferred. Examples of the functional group include a radically polymerizable functional group and a functional group such as epoxy group, and a radically polymerizable functional group is preferred. As the radically polymerizable functional group, a vinyl group is preferred. As the vinyl group, one or more selected from the group consisting of an allyl group, a (meth)acryloyl group and an aromatic vinyl group are preferred, one or more selected from the group consisting of a (meth)acryloyl group and an aromatic vinyl group are more preferred, and an aromatic vinyl group is most preferred. In other words, in the composition of the present invention, a bifunctional polyphenylene ether with both ends of the molecular chain modified with a radically polymerizable functional group is particularly preferred. Examples of the polyphenylene ether include Noryl (trademark) SA9000 manufactured by SABIC (modified polyphenylene ether having methacryloyl groups at both ends, number average molecular weight: 2200) and a bifunctional polyphenylene ether oligomer manufactured by MITSUBISHI GAS CHEMICAL COMPANY, INC. (OPE-2St, modified polyphenylene ether having a vinylbenzyl group at both ends, number average molecular weight: 1200). An allylated PPE manufactured by Asahi Kasei Corporation may also be used. Among these, a bifunctional polyphenylene ether oligomer (OPE-2St) manufactured by MITSUBISHI GAS CHEMICAL COMPANY, INC. may be preferably used. The amount of polyphenylene ether used in the composition of the present invention is preferably 1 to 200 parts by mass, more preferably 1 to 100 parts by mass, relative to 100 parts by mass of the copolymer.

### <Aromatic polyene-based resin>

The aromatic polyene-based resin includes divinylbenzene-based reactive multibranched copolymers (PDV, ODV) manufactured by NIPPON STEEL Chemical & Material CO., LTD. Such multibranched copolymers are described, for example, in literature "Synthesis of polyfunctional aromatic vinyl copolymer and development of new lPN-type low dielectric loss material using same" (Masao Kawabe et al., Journal of Electronics Packaging Society, pp. 125-129, Vol. 12, No. 2 (2009)), U.S. Patent No. 8404797, and International Publication No. WO 2018/181842. Examples of the aromatic polyene-based resins also include an aromatic polyene polymer resin having the aromatic polyene monomer described above as main structural unit. The amount of the aromatic polyene-based resin used in the composition of the present invention is preferably 1 to 200 parts by mass, more preferably 1 to 100 parts by mass, and most preferably 1 to 50 parts by mass, relative to 100 parts by mass of the copolymer. Use of the aromatic polyene-based resin in an amount within the ranges is effective in adjusting the mechanical properties of a cured product obtained from the composition, and preferable for preventing deterioration in adhesion to other members and deterioration in toughness. With an amount of 200 parts by mass or less, brittleness is not exhibited and adhesion to other members is improved.

### <(c) Polar monomer>

The amount of the polar monomer usable in the composition of the present invention is preferably 100 parts by mass or less relative to 100 parts by mass of the copolymer. The present composition may contain substantially no monomers. The polar monomer is a monomer having one or more atoms selected from oxygen, nitrogen, phosphorus, and sulfur in the molecule, and the polar monomer that can be suitably used has a molecular weight of preferably less than 5000, more preferably less than 1000, and still more preferably less than 500. The polar monomer that may be suitably used in the composition of the present invention is preferably a polar monomer that may be polymerized by a radical polymerization initiator. Examples of the polar monomer include various maleimides, bismaleimides, maleic anhydride, triallyl isocyanurate, glycidyl (meth)acrylate, tri(meth)acrylic isocyanurate, and trimethylolpropane tri(meth)acrylate. The maleimides and bismaleimides that may be used in the present invention are described in, for example, International Publication No. WO 2016/114287 and Japanese Patent Laid-Open No. 2008-291227, and may be purchased from Daiwa Kasei Industry Co., Ltd., Nippon Kayaku Co., Ltd., or Designer Molecule Inc. A bismaleimide-based resin "SLK" manufactured by Shin-Etsu Chemical Co., Ltd. may also be used. The maleimide group-containing compounds are preferably bismaleimides from the viewpoints of solubility in organic solvents, high-frequency characteristics, high adhesion to conductors, and moldability of prepreg. The maleimide group-containing compounds may be used as polyamino bismaleimide compounds from the viewpoints of solubility in organic solvents, high frequency characteristics, high adhesion to conductors, and moldability of prepreg. A polyamino bismaleimide compound is obtained, for example, by Michael addition reaction between a compound having two maleimide groups at the terminals and an aromatic diamine compound having two primary amino groups in the molecule. In the case of achieving a high cross-linking efficiency with a small amount of addition, use of a polar monomer having a multifunctional group with two or more functional groups such as bismaleimides, triallyl isocyanurate (TAIC), trimethylolpropane tri(meth)acrylates is preferred. The amount of the polar monomer used in the composition of the present invention is preferably 0.1 to 20 parts by mass, more preferably 0.1 to 10 parts by mass, relative to 100 parts by mass of the copolymer. With use in an amount in the range, an effect of having a not too high dielectric constant and a not too high dielectric loss tangent of the resulting cured product may be obtained, so that the dielectric constant may be suppressed to 4.0 or less, preferably 3.0 or less, and the dielectric loss tangent may be suppressed to 0.005 or less, preferably 0.002 or less.

On an as needed basis, to the composition of the present invention, the "aromatic vinyl compound" such as styrene, the "aromatic polyene" such as divinylbenzene, and an "aromatic vinylene compound" may be appropriately added. The amount of the additives added may be freely selected, and is preferably 100 parts by mass or less relative to 100 parts by mass of the copolymer. The aromatic vinylene compound refers to a compound having both a single aromatic ring or a plurality of condensed aromatic rings having 9 to 30 carbon atoms and a vinylene group. Examples of the aromatic vinylene compound include indenes, beta-substituted styrenes and acenaphthylenes. Examples of indenes include indene, various alkyl-substituted indenes and phenyl-substituted indenes. Examples of beta-substituted styrenes include β-alkyl-substituted styrene such as β-methylstyrene, and phenyl-substituted styrene. Examples of acenaphthylenes include acenaphthylene, various alkyl-substituted acenaphthylenes, and various phenyl-substituted acenaphthylenes. As the aromatic vinylene compound, the exemplified compounds may be used alone, or two or more thereof may be used in combination. The aromatic vinylene compound preferably has a boiling point of 175°C or more under normal pressure. From the viewpoint of industrial availability and radical polymerizability, acenaphthylene is most preferred as the aromatic vinylene compound.

The composition of the present invention may further contain one or more selected from (d) fillers and (e) flame retardants.

### <Filler>

A known inorganic or organic filler may be added on an as needed basis. The filler is added for controlling the coefficient of thermal expansion, controlling the thermal conductivity, or reducing cost, and the amount used may be freely selected depending on the purpose. In particular, in the case of adding an inorganic filler, use of a known surface modifier such as silane coupling agent is preferred. In particular, for the purpose of making a composition excellent in low dielectric constant and low dielectric loss, which is one of the objects of the present invention, the inorganic filler is preferably one or more of boron nitride (BN) and silica, more preferably silica. As the silica, fused silica is preferred. From the viewpoint of low dielectric properties, a large amount addition results in increase of the dielectric constant, in particular. Accordingly, a filler in an amount of preferably less than 500 parts by mass, more preferably less than 400 parts by mass, is used relative to 100 parts by mass of the copolymer. Furthermore, in order to improve low dielectric properties (low dielectric constant, low dielectric loss tangent), a hollow filler or a filler having a shape with many voids may be added.

The average particle size (d50) of the filler is preferably 0.01 to 100 µm, more preferably 0.1 to 10 µm, and most preferably 0.3 to 1 µm. Here, d50 is the value at a cumulative volume of 50%. The average particle size (d50) is determined from a volume particle size distribution curve obtained using a laser diffraction particle size analyzer ("Model LS-230" manufactured by Beckman Coulter).

The specific surface area is preferably 1 to 30 m²/g, more preferably 3-10 m²/g.

The specific surface area is measured by the following method. A measurement cell is filled with 1 g of a sample, and the specific surface area is measured using a Macsorb HM model-1201 full-automatic specific surface area measuring device manufactured by Mountech Co., Ltd. (BET single point method). The degassing condition before measurement is at 200°C for 10 minutes. Nitrogen is used as the adsorbing gas.

The volume ratio between the resin component and the filler may be in the range of 98 to 15:2 to 85, preferably in the range of 85 to 15:15 to 85, more preferably in the range of 85 to 30:15 to 70, and still more preferably in the range of 80 to 60:20 to 40.

Alternatively, an organic filler such as high-molecular-weight polyethylene or ultra-high-molecular-weight polyethylene may be used instead of the inorganic filler. From the viewpoint of heat resistance, it is preferable that the organic filler itself be crosslinked, and blended in the form of fine particles or powder. The organic fillers may suppress increases in dielectric constant and dielectric loss tangent.

On the other hand, a high dielectric insulator filler having a dielectric constant of preferably 4 to 10000, more preferably 5 to 10000 at 1 GHz is mixed and dispersed into the composition of the present invention, so that an insulating cured product having an insulating layer with a high dielectric constant of preferably 4 to 20 may be produced while an increase in dielectric loss tangent (dielectric loss) is suppressed. With an increase in the dielectric constant of a film made of the insulating cured product, the circuit size may be reduced and the capacity of a capacitor may be increased, which contributes to size reduction of high-frequency electric parts. An insulating layer with a high dielectric constant and a low dielectric loss tangent is suitable for use in capacitors, inductors for resonant circuits, filters, and antennas. Examples of the high dielectric constant insulator filler used in the present invention include inorganic fillers and metal particles subjected to insulation treatment. Specific examples thereof include known high dielectric constant inorganic fillers such as barium titanate and strontium titanate, and other examples are specifically described in, for example, Japanese Patent Laid-Open No. 2004-087639.

### <Flame retardant>

Flame retardants may be used in the composition of the present invention. Preferred flame retardants are one or more selected from organophosphorus-based flame retardants such as phosphates or condensates thereof, bromine-based flame retardants, and red phosphorus from the viewpoint of maintaining a low dielectric constant and a low dielectric loss tangent. Among phosphates, compounds having a plurality of xylenyl groups in the molecule are particularly preferred from the viewpoint of flame retardancy and low dielectric loss tangent.

In addition to flame retardants, antimony-based compounds such as antimony trioxide, antimony tetroxide, antimony pentoxide, sodium antimonate, or nitrogen-containing compounds such as melamine, triallyl-1 ,3,5-triazine-2,3,4-(1H,3H,5H)-trione and 2,4,6-triaryloxy-1 ,3,5-triazine may be added as flame retardant aids. The total amount of the flame retardants and flame retardant aids is usually preferably 1 to 100 parts by mass relative to 100 parts by mass of the composition. Further, 30 to 200 parts by mass of a polyphenylene ether (PPE)-based resin having a low dielectric constant and excellent flame retardancy may be used relative to 100 parts by mass of the flame retardant.

The composition of the present invention may further contain (f) solvent. Among the compositions of the present invention, those that are particularly in a liquid state due to containing a solvent are referred to as varnishes.

### <Solvent>

A suitable solvent may be added to the composition of the present invention, on an as needed basis. The amount thereof used is not particularly limited. The solvent is used to adjust the viscosity and fluidity of the composition. In particular, in the case where the composition of the present invention is in a varnish state, a solvent is preferably used. Since a solvent having a too low boiling point under atmospheric pressure, that is, a solvent having too high volatility, may cause an uneven thickness of the applied film, a solvent having a boiling point above a certain level is preferably used. A preferable boiling point is approximately 100°C or more, more preferably 110°C or more and 300°C or less under atmospheric pressure. As the solvent, for example, cyclohexane, toluene (boiling point: 110°C), ethylbenzene, xylene, mesitylene, tetralin, acetone, limonene, a mixed alkane, or a mixed aromatic-based solvent is used. The amount of solvent used in the composition of the present invention may be freely selected, and is preferably 5 to 500 parts by mass, more preferably 10 to 300 parts by mass, and most preferably 50 to 150 parts by mass, relative to 100 parts by mass of the copolymer.

The composition and varnish of the present invention may contain additives that are usually used in a resin, such as antioxidants, weathering agents, light stabilizers, lubricants, compatibilizers, and antistatic agents, in the range not impairing the effect and purpose of the present invention. The composition and varnish of the present invention may be obtained by mixing, dissolving, or melting the various additives described above, and any known methods for mixing, dissolving, and melting may be employed.

### <Varnish>

The varnish of the present invention may be in a viscous state at room temperature or by heating to 100°C or less, through adjustment of the composition and molecular weight of the copolymer to be used, addition of a certain amount or more of a liquid monomer or solvent within the scope of the present invention, or addition of a liquid flame retardant, and has a viscosity at room temperature of, for example, several hundred thousand mPa·s or less, preferably 2000 mPa·s or less, more preferably 1000 mPa·s or less, and most preferably 500 mPa·s or less. Here, the viscosity is measured by, for example, a rotational viscometer. Specifically, another material is coated, impregnated, or filled with the varnish, or the varnish is dripped onto another material by an appropriate method and the solvent is removed to obtain a molded product. Furthermore, a desired cured product may be obtained by curing with heat or light. Such properties allow a multilayer structure containing an insulating layer I to be formed through various transfer molding (press fitting), coating on or between a substrate and a semiconductor device material, or extrusion lamination or spin coating to form a sheet or film, and then through curing.

### <Multilayer structure including insulating layer>

The molded product of the insulating layer obtained from the composition of the present invention is in a sheet shape. The thickness thereof may be freely selected, and is preferably in the range of 10 µm to 1 mm. The composition may exhibit thermoplastic properties. Accordingly, the composition may be molded into a shape such as sheet in a substantially uncured state by a known molding method of thermoplastic resins, such as extrusion molding, injection molding, press molding and inflation molding, under conditions not causing cross-linking, and then may be laminated with another layer to be crosslinked (cured). For example, the composition in a varnish state may be applied to another base material such as a smooth surface of copper foil, and then the solvent is removed by heating, decompressing, air drying, etc., so that a molded product in a sheet or film form may be obtained, which is then laminated and crosslinked (cured). Alternatively, a porous base material, woven fabric or non-woven fabric may be impregnated with the varnish of the present invention, and the solvent is removed, so that a composite sheet as the multilayer structure may be obtained. These sheets may be in an uncured (semi-cured) state to an extent that the sheet shape may be maintained, or may be in a completely cured state. The degree of curing of the composition may be quantitatively measured by a known dynamic viscoelasticity measurement method (DMA, Dynamic Mechanical Analysis).

### <Curing process>

Curing of the multilayer structure described above may be performed by a known method with reference to the curing conditions (temperature, time, pressure and light) of the raw materials and curing agent contained. In the case of using a peroxide as curing agent, curing conditions such as heating conditions may be determined with reference to the half-life temperature and the like usually disclosed for each peroxide.

### <Cured multilayer structure>

The cured multilayer structure of the present invention may be sufficiently cured, and the cured insulating layer may have a gel content of 90 mass% or more as measured according to ASTM. The dielectric constant of the cured insulating layer is preferably 3.0 or less and 2.0 or more, more preferably 2.8 or less and 2.0 or more, and most preferably 2.5 or less and 2.0 or more, in a measurement range of 10 to 50 GHz, particularly preferably at 10 GHz. The dielectric loss tangent is preferably 0.003 or less and 0.0005 or more, more preferably 0.002 or less and 0.0008 or more. The resulting cured insulating layer having a volume resistivity of 1×10¹⁵ Ω·cm or more and a water absorption rate of 0.1 mass% or less is preferred as an electrical insulating material. These values are particularly preferable for an electrical insulating material for high frequencies of, for example, 3 GHz or more.

The cured insulating layer contained in the multilayer structure has high adhesion even to the smooth surface of copper foil for wiring. The adhesive strength is preferably 0.8 N/mm or more, more preferably 1.0 N/mm or more. Accordingly, the cured product is particularly preferable as an interlayer insulating material or a coverlay. At least a part or at least one surface of an interlayer insulating material used for multilayer CCL or FCCL needs to be bonded to the smooth surface of a copper foil. The cured composition exhibits high adhesion to the smooth surface of copper foil, and is therefore preferred for the use. Since the lower surface of a coverlay needs be bonded to the smooth surface of copper foil on the substrate, the cured product of the composition, which exhibits high adhesion to the smooth surface of copper foil, is preferred.

Examples of the method for manufacturing high-frequency transmission lines, antennas, and multilayer substrates (CCL, FCCL) having a multilayer structure of the present invention may include the following methods. Examples of the method of making a multilayer substrate includes applying a composition as varnish to a substrate (resin layer), which is bonded to the roughened surface of copper foil to have an upwardly open smooth surface of copper foil, removing the solvent to form an insulating layer, then laying another resin layer thereon to form a multilayer structure, and treating the laminate under appropriate temperature and pressure conditions to be cured and bonded. Alternatively, another method of making a multilayer substrate includes placing an uncured sheet prepared in advance as insulating layer on a substrate (resin layer), which is bonded to the roughened surface of copper foil to have an upwardly open smooth surface of copper foil, further laying another resin layer thereon to form a multilayer structure, and treating the laminate under appropriate temperature and pressure conditions to be cured and bonded.

Examples of the method for manufacturing a substrate having a coverlay include the following processes. Examples of the method for forming a coverlay include applying a composition as varnish to a substrate, which is bonded to the roughened surface of copper foil to have an upwardly open smooth surface of copper foil, removing the solvent, then applying pressure and heat under predetermined conditions to cure the insulating layer. Alternatively, another method includes laminating an uncured sheet of the composition prepared in advance to a substrate, which is bonded to the roughened surface of copper foil to have an upwardly open smooth surface of copper foil, and then applying pressure and heat to cure the insulating layer to be bonded.

From another point of view, the present invention relates to an interlayer insulating material including a cured composition containing an olefin-aromatic vinyl compound-aromatic polyene copolymer as a main component, and 0.001 to 10 parts by mass of a silane coupling agent relative to the olefin-aromatic vinyl compound-aromatic polyene copolymer, and can provide high-frequency transmission lines such as microstrip lines, antennas, multilayer CCL substrates or multilayer FCCL substrates containing the interlayer insulation material. The interlayer insulating material layer is an interlayer insulating material having at least a part thereof or one surface thereof in contact with the smooth surface of copper foil. A layer including the interlayer insulating material is characterized by good low dielectric performance, heat resistance, and high adhesion to the smooth surface of a copper foil of the substrate.

From another point of view, the present invention relates to a coverlay containing an olefin-aromatic vinyl compound-aromatic polyene copolymer as main component, and 0.001 to 10 parts by mass of a silane coupling agent relative to the olefin-aromatic vinyl compound-aromatic polyene copolymer, and a substrate including the coverlay. At least the lower surface of the coverlay is in contact with the smooth surface of copper foil of the substrate. The coverlay is characterized by the excellent low dielectric performance, heat resistance, and high adhesion to the smooth surface of copper foil of the substrate.

A known method may be used to bond the insulating layer of the present invention to a resin layer made of other resin materials used in CCL or FCCL. Examples of the method includes subjecting the resin layer to corona treatment or plasma treatment in advance to activate the surface, or forming unevenness on the surface to be roughened. Furthermore, the insulating layer made of the composition of the present invention may exhibit a higher adhesive strength to, for example, polyimide (PI), liquid crystal polymer (LCP), polyphenylene ether (PPE), polyfunctional aromatic vinyl resin (ODV), epoxy resin, or each resin or sheet of the same composition as in insulating layer I, as compared with the case where no surface modifier is added. In particular, higher adhesion can be expected in the case where the surface of these resin sheets is treated by surface treatment such as corona treatment or plasma treatment as described above.

### EXAMPLES

The present invention will be described below with reference to Examples, though the present invention is not limited to the following Examples. The copolymers obtained in Synthesis Examples and Comparative Synthesis Examples were analyzed by the following methods.

The content of each of the vinyl group units derived from ethylene, hexene, styrene, and divinylbenzene in the copolymer was determined from peak area intensity attributed to each in ¹H-NMR. The sample was dissolved in heavy 1,1,2,2-tetrachloroethane and measurement was performed at 50 to 130°C.

As for the molecular weight, GPC (gel permeation chromatography) was used to determine the number average molecular weight (Mn) in terms of standard polystyrene. Measurement was performed under the following conditions.

Column: Two TSK-GEL Multipore HXL-M having a diameter of 7.8 mm and a length of 300 mm (manufactured by Tosoh Corporation) were connected in series for use.
Column temperature: 40°C
Solvent: THF
Liquid sending rate: 1.0 ml/min
Detector: RI detector

### <Gel fractions>

The gel fraction was determined as insoluble fraction in boiling toluene according to ASTM D2765-84.

### <Water absorption rate>

According to ASTM D570-98, the water absorption rate was measured after immersion in pure water at 23°C for 24 hours.

### <Dielectric constant and dielectric loss (dielectric loss tangent)>

The dielectric constant and dielectric loss tangent of a sample having sizes of 1 mm by 1.5 mm by 80 mm cut from a sheet were measured at 23°C and 10 GHz by the cavity resonator perturbation method (network analyzer 8722ES manufactured by Agilent Technologies, and cavity resonator manufactured by Kanto Electronics Application & Development Inc.).

### <Volume resistivity>

Using a film with a thickness of about 0.5 mm, measurement was performed at room temperature according to JIS K6911: 2006.

### <Adhesive strength (peel strength) between insulating layer and smooth surface of copper foil>

A copper foil manufactured by MITSUI MINING &SMELTING CO., LTD. (VSP series, TQ-M7-VSP, thickness: 12 µm, surface roughness of roughened surface Rz: 1.1 µm) was used.

A copper foil with the smooth surface on the upper side was placed on a Teflon (registered trademark) sheet, and several uncured sheets as insulating layer I were placed on the smooth surface. A formwork made of SUS (thickness: 0.2 mm) was placed thereon, and a Teflon sheet was further laid. A load of 5 MPa was applied thereon with a press, and heat treatment was performed for curing at 120°C for 30 minutes, 150°C for 30 minutes, and then at 200°C for 120 minutes. Here, the insulating layer I is an uncured sheet in Examples and Comparative Examples to be described later. After curing, the Teflon sheet and the formwork were removed, so that a multilayer structure including the sheet cured and bonded to the copper foil was obtained. The adhesive strength with copper foil was measured according to Japanese Industrial Standards (JIS) C6471: 1995, and peeling was evaluated at 180°. As a reference, the copper foil with the roughened surface on the upper side was placed on a Teflon sheet, and several uncured sheets were laid thereon to obtain a laminate cured and bonded to the roughened surface of copper foil, which was subjected to the measurement of the adhesive strength in the same manner.

### <Production of copolymer>

### Synthesis Examples P-1 and P-2

With reference to the production methods described in Japanese Patent Laid-Open No. 2009-161743 and Japanese Patent Laid-Open No. 2010-280771, using Rac-dimethylmethylene bis(4,5-benzo-1-indenyl)zirconium dichloride (structure: refer to the following formula (1)) as catalyst, modified methyl aluminoxane (manufactured by Tosoh Finechem Corporation, MMAO-3A toluene solution) as cocatalyst, cyclohexane as solvent, styrene, divinylbenzene, and ethylene as raw materials, and 1-hexene on an as needed basis, polymerization was performed in an autoclave having a volume of 10 L, equipped with a stirrer and a jacket for heating and cooling. To the resulting polymerization solution, 1-Isopropanol was added, and then a large amount of methanol was added to collect a copolymer. The copolymer was air-dried and then vacuum-dried at 30°C for one whole day and night to obtain copolymers P-1 and P-2. In Table 1, the composition and number average molecular weight of the copolymers are shown.

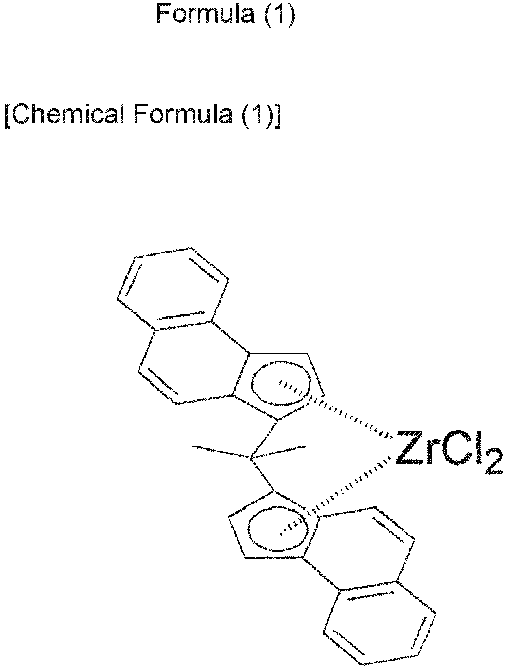

### Synthesis Example P-3

With reference to the production methods described in Japanese Patent Laid-Open No. 9-40709, Japanese Patent Laid-Open No. 9-309925, Japanese Patent Laid-Open No. 2009-161743 and Japanese Patent Laid-Open No. 2010-280771, using dimethylmethylene biscyclopentadienyl zirconium dichloride (structure: refer to the following formula (2)) as catalyst, modified methyl aluminoxane (manufactured by Tosoh Finechem Corporation, MMAO-3A toluene solution) as cocatalyst, cyclohexane as solvent, and styrene, divinylbenzene, and ethylene as raw materials, polymerization was performed in an autoclave having a volume of 10 L, equipped with a stirrer and a jacket for heating and cooling. To the resulting polymerization solution, 1-lsopropanol was added, and then a large amount of methanol was added to collect a copolymer. The copolymer was spread thinly in a large container and vacuum-dried at 30°C for 2 days and nights. In Table 1, the composition and number average molecular weight of the copolymer P-3 are shown.

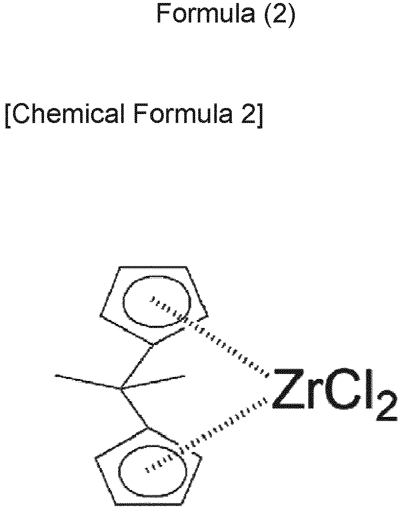

Other raw materials are as follows.

Bifunctional polyphenylene ether oligomer (OPE-2St, number average molecular weight: 1200) in a powder form for use was obtained by further diluting a toluene solution product manufactured by MITSUBISHI GAS CHEMICAL COMPANY, INC. with toluene, adding a large amount of methanol to perform methanol precipitation, air-drying, and drying under reduced pressure. As 1,2-polybutadiene, "B-3000" manufactured by NIPPON SODA CO., LTD., having a number average molecular weight of 3200 and a viscosity of 210 Poise (21000 mPa·s at 45°C) was used. As BMI, BMI-5100 (3,3'-dimethyl-5,5'-diethyl-4,4'-diphenylmethane bismaleimide) manufactured by Daiwa Kasei Industry Co., Ltd. was used. As silane coupling agent, KBM-503 (3-methacryloxypropyl trimethoxysilane), KBM-403 (3-glycidoxypropyl trimethoxysilane), or KBM-1403 (p-styryl trimethoxysilane) manufactured by Shin-Etsu Chemical Co., Ltd. was used. As curing agent, Perhexyne 25B (organic peroxide, 2,5-dimethyl-2,5-bis(t-butylperoxy)hexyne-3) manufactured by NOF CORPORATION was used.

**[Table 1]**

| | Ethylene content | 1-Hexene content | Styrene content | Divinylbenzene vinyl group | Number average molecular weight |
|---|---|---|---|---|---|
| Copolymerized oligomer or polymer | mass% | mass% | mass% | (pieces/number average molecular weight) | Mn |
| P-1 | 39 | 0 | 59 | 6.0 | 36000 |
| P-2 | 47 | 3 | 46 | 5.6 | 18000 |
| P-3 | 51 | 0 | 40 | 3.8 | 5800 |

**[Table 2]**

| | Example 1 | Example 2 | Example 3 | Example 4 | Example 5 | Example 6 |
|---|---|---|---|---|---|---|
| P-1 | 100 | 100 | 100 | 100 | 100 | - |
| P-2 | - | - | - | - | - | 100 |
| P-3 | - | - | - | - | - | - |
| Bifunctional polyphenylene ether oligomer (OPE-2St) | - | - | - | - | 50 | 50 |
| 1,2-polybutadiene | - | - | - | - | - | - |
| Bismaleimide (BMI-5100) | - | - | - | - | - | - |
| KBM-503 | 5 | 1 | - | - | 1 | 1 |
| KBM-403 | - | - | 5 | - | - | - |
| KBM-1403 | - | - | - | 5 | - | - |
| Silica filler (SFP-130MC) | - | - | - | - | - | - |
| Solvent (toluene) | 200 | 200 | 200 | 200 | 200 | 200 |
| Curing agent* | 1 | 1 | 1 | 1 | 1 | 1 |
| Gel fraction (/%) | >90 | >90 | >90 | >90 | >90 | >90 |
| Dielectric constant (10 GHz) | 2.4 | 2.4 | 2.4 | 2.4 | 2.5 | 2.4 |
| Dielectric loss tangent (10 GHz) | 0.0011 | 0.0010 | 0.0011 | 0.0015 | 0.0014 | 0.0013 |
| Water absorption rate (mass%) | <0.1 | <0.1 | <0.1 | <0.1 | <0.1 | <0.1 |
| Volume resistivity (Ω/cm) | >10¹⁵ | >10¹⁵ | >10¹⁵ | >10¹⁵ | >10¹⁵ | >10¹⁵ |
| Adhesive strength to smooth surface of copper foil (N/mm) | >1 N (material failure) | >1 N (material failure) | >1 N (material failure) | >1 N (material failure) | >1 N (material failure) | >1 N (material failure) |

| | | | | | | |
|---|---|---|---|---|---|---|
| * 1 Part by mass was added to 100 parts by mass of resin components in total excluding curing agent, solvent, silane coupling agent, and filler. | | | | | | |

**[Table 3]**

| | Example 7 | Example 8 | Example 9 | Example 10 | Comparative Example 1 | Comparative Example 2 |
|---|---|---|---|---|---|---|
| P-1 | - | 50 | 100 | 100 | 100 | 100 |
| P-2 | - | - | - | - | - | - |
| P-3 | 100 | 50 | - | - | - | - |
| Bifunctional polyphenylene ether oligomer (OPE-2St) | - | - | - | - | - | 50 |
| 1,2-polybutadiene | 30 | - | - | - | - | - |
| Bismaleimide (BMI-5100) | - | - | 10 | - | - | - |
| KBM-503 | - | 1 | 1 | 3 | - | - |
| KBM-403 | 1 | - | - | - | - | - |
| KBM-1403 | - | - | - | - | - | - |
| Silica filler (SFP-130MC) | - | - | - | 30 vol% silica filler to 70 vol% resin component | - | - |
| Solvent (toluene) | 200 | 200 | 200 | 300 | 200 | 200 |
| Curing agent* | 1 | 1 | 1 | 1 | 1 | 1 |
| Gel fraction (/%) | >90 | >90 | >90 | >90 | >90 | >90 |
| Dielectric constant (10 GHz) | 2.3 | 2.3 | 2.3 | 2.7 | 2.3 | 2.3 |
| Dielectric loss tangent (10 GHz) | 0.0012 | 0.0012 | 0.0013 | 0.0015 | 0.0006 | 0.0013 |
| Water absorption rate (mass%) | <0.1 | <0.1 | <0.1 | <0.1 | <0.1 | <0.1 |
| Volume resistivity (Ω/cm) | >10¹⁵ | >10¹⁵ | >10¹⁵ | >10¹⁵ | >10¹⁵ | >10¹⁵ |
| Adhesive strength to smooth surface of copper foil (N/mm) | >1 N (material failure) | >1 N (material failure) | >1 N (material failure) | >1 N (material failure) | 0.4 | 0.3 |

| | | | | | | |
|---|---|---|---|---|---|---|
| * 1 Part by mass was added to 100 parts by mass of resin components in total excluding curing agent, solvent, silane coupling agent, and filler. | | | | | | |

### Example 1

In a container equipped with a heating and cooling jacket and a stirring blade, P-1 (ethylene-styrene-divinylbenzene copolymer) obtained in Synthesis Example, solvent (toluene), and silane coupling agent KBM-503 in a ratio shown in Table 2 were heated to about 40°C and stirred to dissolve the copolymer. Further, 1 part by mass of a curing agent (dicumyl peroxide) was added to 100 parts by mass of the resin component excluding the curing agent, solvent and silane coupling agent, and dissolved and mixed with stirring to obtain a composition in a varnish state. The resulting composition was poured into a silicon framework (frame part having a length of 7 cm, a width of 7 cm, and a thickness of 0.5 mm, 1.0 mm, or 2.0 mm) on a Teflon sheet placed on a glass sheet, air-dried, and then dried in a vacuum dryer at 60°C for 3 hours or more, so that an uncured sheet was obtained. Further, on the resulting uncured sheet, a Teflon sheet and a SUS framework were placed under a load of 5 MPa with a press, and subjected to heat treatment at 120°C for 30 minutes, 150°C for 30 minutes, and then at 200°C for 120 minutes. The Teflon sheet and the SUS formwork were then removed, so that a cured sheet was obtained.

### Examples 2 to 9 and Comparative Examples 1 and 2

In the same procedure as in Example 1, a curable composition with the formulation in Table 2 or Table 3 (units in the tables: parts by mass) was prepared, and in the same procedure, an uncured sheet and a cured sheet of the composition in Examples and Comparative Examples were obtained.

The gel fraction, dielectric constant, dielectric loss tangent, water absorption rate and volume resistivity of the cured sheets are shown in Tables 2 and 3.

Further, the results of the adhesive strength at the interface of the cured multilayer structure including the smooth surface of copper foil and the insulating layer I determined by the method described above are shown in Tables 2 and 3. Here, the insulating layer I is an uncured sheet of Examples and Comparative Examples. In Examples, the measured adhesive strength at the interface between the smooth surface of copper foil and the insulating layer I was too high, and at a value of 1 N/mm or more, the fracture (material failure) or full stretch of a resin part, or fracture (material breakage) of the copper foil occurred. That is, in these cases, the adhesive strength was 1 N/mm or more. In contrast, in Comparative Examples 1 and 2, the values of 0.4 N/mm and 0.3 N/mm were shown, respectively. As a reference, the adhesive strength at the interface between the roughened surface of the copper foil and the insulating layer I was measured in the same manner, and all the samples in Examples and Comparative Examples had an adhesive strength of 1 N/mm or more. That is, the composition according to the present Examples can provide a cured product exhibiting high adhesive strength to both the smooth surface and the roughened surface of a copper foil.

### Example 10

Using the same apparatus as in Example 1, 1 part by mass of P-1 (ethylene-styrene-divinylbenzene copolymer), toluene, silane coupling agent KBM-503, and curing agent (dicumyl peroxide) were added to 100 parts by mass of the present resin component, dissolved, stirred and mixed, so that a composition in a varnish state was obtained. A silica filler (SFP-130MC manufactured by Denka Co., Ltd., d50=0.6 µm, specific surface area: 6.2 m²/g, density: 2.2 g/cm³) was added thereto and stirred to prepare a slurry varnish. Relative to 70 vol% (volume %) of the resin component, 30 vol% of silica filler was used. Relative to a total of 100 parts by mass of resin raw materials other than the curing agent, solvent, silane coupling agent and filler, 1 part by mass of the curing agent was added.

### Example 11

Structure (2) shown in Figure 2 was made. Here, the resin layer A was made of polyimide, and the insulating layer I and the resin layer B were made of a composition containing the copolymer of the present invention.

A multilayer sheet (commercial product, Upicel N, polyimide film: 25 µm, electrolytic copper foil: 18 µm, single-sided copper-clad type) including a roughened surface of copper foil bonded to a polyimide (PI) sheet was prepared. Further, an uncured sheet having a thickness of 500 µm obtained in the same manner as in Example 10 was prepared. A copper foil manufactured by MITSUI MINING &SMELTING CO., LTD. (VSP series, TQ-M7-VSP) was used. An uncured sheet obtained in the same manner as in Example 5 having a thickness of 100 µm (insulating layer I) was placed on an open smooth surface of copper foil which a multilayer sheet including a roughened surface of copper foil bonded to a polyimide (PI) sheet has, and an uncured sheet (resin layer B) having a thickness of 100 µm obtained in Example 10 was further placed on the uncured sheet. Furthermore, a copper foil was placed such that the roughened surface of copper foil came into contact with the resin layer B. A thin Teflon sheet was partially inserted between the smooth surface of copper foil and the uncured sheet (insulating layer I) of Example 5, and curing was performed under the same conditions as in Example 1 under pressure with a press, so that a multilayer structure sheet including a layer A (polyimide)/copper foil/insulating layer l/resin layer B (Example 10)/copper foil laminated and bonded in this order was obtained. After curing, the inserted Teflon sheet was pulled out to trigger a tensile test, and the adhesive strength between the smooth surface of copper foil and the insulating layer I was determined. In the same manner, a thin Teflon sheet was partially inserted between the insulating layer I and the resin layer B, and the adhesive strength between the insulating layer I and the resin layer B of the multilayer-structured sheet obtained by curing in the same manner was determined. At an adhesive strength of 1 N/mm or more, the fracture (material failure) or full stretch of a resin part, or fracture (material breakage) of the copper foil occurred in any of the samples. That is, in these cases, any of the adhesive strength between the smooth surface of copper foil and the insulating layer I and the adhesive strength between the insulating layer I and the resin layer B was 1 N/mm or more. Further, the adhesive strength between the commercially available polyimide (PI) and the roughened surface of copper foil was separately measured to be 1 N/mm or more. From the above, it can be seen that the multilayer structure of the present invention has high adhesive strength at each of the interfaces.

### Example 12

Structure (4) shown in Figure 3 was made. Here, the insulating layer I was made of a composition containing the copolymer of the present invention, and both the resin layers A and B were made of polyimide (PI). An uncured sheet obtained in the same manner as in Example 6 having a thickness of 100 µm (insulating layer I) was placed on an open smooth surface of copper foil of a multilayer sheet (commercial product, the same as in Example 11) including a roughened surface of copper foil bonded to a polyimide (PI) sheet, and a multilayer sheet (commercial product) having a roughened surface of copper foil bonded on a polyimide (PI) sheet was further placed thereon to come in contact with the open smooth surface of copper foil. Curing was performed under the same conditions as in Example 1 under pressure with a press, so that a multilayer structure sheet including a resin layer A (polyimide)/copper foil/insulating layer l/copper foil/resin layer B (polyimide) laminated and bonded in this order was obtained. In the same manner as in Example 11, a thin Teflon sheet was partially inserted between the smooth surface of copper foil and the uncured sheet (insulating layer I) in Example 6 in advance. The thin Teflon sheet was then pulled out to trigger a tensile test, and the adhesive strength between the smooth surface of copper foil and the insulating layer I was determined. As a result, at an adhesive strength of 1 N/mm or more, the fracture (material failure) of the resin part occurred. That is, the adhesive strength between the smooth surface of copper foil and the insulating layer I was 1 N/mm or more.

### Example 13

Fundamental unit structure shown in Figure 1 was made. Here, the insulating layer I was made of a composition of the copolymer of the present invention, and both the resin layer A was made of polyimide. An uncured sheet obtained in the same manner as in Example 2 having a thickness of 500 µm (insulating layer I) was placed on an open smooth surface of copper foil of a multilayer sheet (commercial product, the same as in Example 11) including a roughened surface of copper foil bonded to a polyimide (PI) sheet, and a thin Teflon sheet was partially inserted between the smooth surface of copper foil and the uncured sheet (insulating layer I). Curing and bonding were performed under the same conditions as in Example 1 under pressure with a press, so that a cured sheet with a multilayer structure including a resin layer A (polyimide)/copper foil/insulating layer I was obtained. The inserted Teflon sheet was then pulled out to trigger a tensile test, and the adhesive strength between the smooth surface of copper foil and the insulating layer I was determined. As a result, at an adhesive strength of 1 N/mm or more, the fracture (material failure) or full stretch of a resin part, or fracture (material breakage) of the copper foil occurred. That is, the adhesive strength between the smooth surface of copper foil and the insulating layer I was 1 N/mm or more.

### Example 14

Fundamental unit structure shown in Figure 1 was made. The copper foil for use was made by Mitsui Mining & Metals Corporation (VSP series, TQ-M7-VSP). Here, both the insulating layer I and the resin layer A were made of a composition of the copolymer of the present invention. A copper foil was placed on an uncured sheet obtained in the same manner as in Example 10 having a thickness of 500 µm (insulating layer A) with the roughened surface contacted. On the smooth surface, an uncured sheet obtained in the same manner as in Example 2, having a thickness of 500 µm (insulating layer I), was further placed. A thin Teflon sheet was partially inserted between the smooth surface of copper foil and the uncured sheet (insulating layer I). Curing and bonding were performed under the same conditions as in Example 1 under pressure with a press, so that a cured sheet with a multilayer structure including a resin layer A (Example 10)/copper foil/insulating layer I was obtained. The inserted Teflon sheet was then pulled out to trigger a tensile test, and the adhesive strength between the smooth surface of copper foil and the insulating layer I was determined. As a result, at an adhesive strength of 1 N/mm or more, the fracture (material failure) or full stretch of a resin part, or fracture (material breakage) of the copper foil occurred. That is, the adhesive strength between the smooth surface of copper foil and the insulating layer I was 1 N/mm or more.

A cured insulating layer made of the composition of the present invention is sufficiently cured with a high gel fraction, and can exhibit a low dielectric constant, a low dielectric loss tangent, a low water absorption rate, and a high resistivity. The cured multilayer structure of the present invention may exhibit high adhesive strength not only to the roughened surface of a copper foil but also to the smooth surface of a copper foil. Accordingly, high adhesion between layers each may be achieved, and the cured multilayer structure is useful as a high frequency transmission line, a multilayer CCL, a multilayer FCCL, an interlayer insulating layer (interlayer insulating material) of antenna, or a coverlay.

## Claims

1. A multilayer structure comprising:
at least one insulating layer(s);
at least one resin layer(s); and
at least one copper foil(s) each having a smooth surface and a roughened surface,
wherein the insulating layer contains an olefin-aromatic vinyl compound-aromatic polyene copolymer and a surface modifier,
wherein the resin layer contains one or more selected from the group consisting of polyimide (PI), liquid crystal polymer (LCP), polyphenylene ether (PPE), polyfunctional aromatic vinyl resin (ODV), epoxy resin, and the same composition as in the insulating layer,
wherein at least one surface of each of the respective insulating layer(s) is bonded to a smooth surface of the copper foil, and
wherein, for each of the respective resin layer(s):
at least one surface of the resin layer is bonded to the roughened surface of the copper foil, and the resin layer is not bonded to the smooth surface of the copper foil; or
both surfaces of the resin layer are not bonded to the copper foil.

2. The multilayer structure according to claim 1, wherein at least one surface of the insulating layer has a recessed portion in the lamination direction, and the copper foil is bonded to be fitted in the recessed portion, with a part of the surface bonded to the smooth surface of the copper foil, and another part of the surface bonded to the resin layer.

3. The multilayer structure according to claim 1 or 2, wherein the surface modifier is a silane coupling agent.

4. The multilayer structure according to any one of claims 1 to 3, wherein the olefin-aromatic vinyl compound-aromatic polyene copolymer satisfies all of the following conditions (1) to (4):
(1) The copolymer has a number average molecular weight of 500 or more and less than 100000;
(2) The aromatic vinyl compound monomer is an aromatic vinyl compound having 8 or more and 20 or less carbon atoms, and the content of the aromatic vinyl compound monomer unit is 0 to 98 mass% or less;
(3) The aromatic polyene is one or more selected from polyenes having 5 to 20 carbon atoms and having a plurality of vinyl groups and/or vinylene groups in the molecule, and the content of the vinyl groups and/or the vinylene groups derived from aromatic polyene units is 1.5 pieces or more and less than 20 pieces per number average molecular weight; and
(4) The olefin is one or more selected from olefins having 2 or more and 20 or less carbon atoms, and a content of olefin monomer units is 10 mass% or more, wherein a total amount of the olefin monomer units, aromatic vinyl compound monomer units, and aromatic polyene monomer units is 100 mass%.

5. The multilayer structure according to any one of claims 1 to 4, wherein the insulating layer further includes one or more selected from the following (a) to (c):
(a) curing agent;
(b) one or more resins selected from hydrocarbon-based elastomers, polyphenylene ether-based resins and, aromatic polyene-based resins; and
(c) polar monomer.

6. The multilayer structure according to any one of claims 1 to 5, wherein the content of the surface modifier in the insulating layer is 0.001 to 10 parts by mass relative to 100 parts by mass of the olefin-aromatic vinyl compound-aromatic polyene copolymer.

7. A cured multilayer structure produced by curing the multilayer structure according to any one of claims 1 to 6.

8. A high frequency transmission line, a multilayer CCL substrate, a multilayer FCCL substrate, an antenna, or a coverlay, comprising the cured multilayer structure according to claim 7.
